# EUROPEAN PATENT SPECIFICATION

(11) **EP 2 913 844 B1**
(45) Date of publication and mention of the grant of the patent: **26.09.2018**
(21) Application number: 13848894.5
(22) Date of filing: 28.10.2013
(51) Int. Cl.: C23C 16/455, C30B 25/14, C23C 16/48, C23C 16/458, C30B 29/06

(54) **EPITAXIAL GROWTH APPARATUS**
VORRICHTUNG FÜR EPITAKTISCHES WACHSTUM
APPAREIL À CROISSANCE ÉPITAXIALE

(30) Priority: 26.10.2012 JP 2012237109
(43) Date of publication of application: 02.09.2015
(73) Proprietor: Applied Materials, Inc., Santa Clara, CA 95024 (US)
(72) Inventor: OKABE, Akira, Ohmura-shi Nagasaki 856-0022 (JP); MORI, Yoshinobu, Ohmura-shi Nagasaki 856-0022 (JP)
(74) Representative: Zimmermann & Partner Patentanwälte mbB
(86) International application number: PCT/JP2013/079126
(87) International publication number: WO 2014/065428

(56) References cited:
- JP-A- 2004 063 779
- JP-A- 2005 307 238
- JP-A- 2005 307 238
- JP-A- 2006 049 503
- JP-A- 2007 324 286
- US-A1- 2007 281 084

## Description

### Technical Field

The present invention relates to an epitaxial growth apparatus.

### Background Art

Conventionally, an epitaxial growth apparatus for growing an epitaxial film on the substrate by epitaxial growth is known (for example, refer to Patent Literature 1). The apparatus comprises a processing chamber; a rotatable substrate support disposed in the processing chamber and configured to rotate a substrate around a rotational axis. A reaction gas is introduced parallel to a horizontal direction of the substrate to be deposited on the substrate on the substrate support.

US 2007/0281084 A1 describes a layer depositing reactor for forming an epitaxial layer. JP 2005 307238 A relates to a film-forming method and apparatus. JP 2007 324286 A relates to a film forming reaction apparatus and its method. JP 2006 049503 A relates to an epitaxially growing apparatus. JP 2004 063779 A relates to an epitaxial wafer manufacturing apparatus and susceptor structure.

### Citation List

### Patent Literature

PTL 1: Japanese Patent Application Publication No. 2001 - 520456

### Summary of Invention

### Problems to be Solved by Invention

For such an epitaxial growth apparatus, it is now required to increase the growth rate. In this case, it is not preferable to include a large amount of a first source gas in a reaction gas in order to increase the growth rate, for example, because the deposition cost increases and particles increase.

Therefore, an object of the present invention is to solve the problems in the prior art described above, and is intended to provide an epitaxial growth apparatus with an improved growth rate.

### Solution to Problem

An epitaxial growth apparatus of the present invention comprises: a reaction chamber defined by a substrate mounting portion on which a substrate is mounted, a ceiling plate with optical transparency and a sidewall portion; a heating means which is mounted outside said reaction chamber and heats the substrate mounted in said reaction chamber through said ceiling plate; and a reaction gas introducing means which introduces a reaction gas parallel to a horizontal direction of the substrate into said reaction chamber, characterized in that a distance between a center of said ceiling plate and the substrate mounted on said substrate mounting portion is configured to be less than 10 mm. In the present invention, the distance between the center of the ceiling plate and the substrate is less than 10 mm, and thereby, it is possible to suppress the spread of the boundary layer when a reaction gas is introduced into the reaction chamber to improve the growth rate.

The epitaxial growth apparatus further includes a susceptor ring provided in an outer periphery of the substrate mounting portion. The susceptor ring consists of a first ring portion provided to be spaced apart with respect to an outer periphery of the substrate mounting portion and a second ring portion provided in an inner peripheral side of said first ring portion and placed in an opened recess.

It is preferable that said ceiling plate is fixed to an annular support portion in which through-holes are formed in a top view; and the through-holes in said support portion have diameters gradually reduced toward said substrate side and said ceiling plate is fixed to an edge portion on the substrate side. By making the support portion in such a shape, the ceiling plate can be supported so that the distance between the center of the ceiling plate and the substrate may be less than 10 mm even in a condition with a high thermal stress.

It is preferable that a supply passage which supplies a reaction gas into said reaction chamber is formed in said sidewall portion; and said supply passage has a wall portion where the reaction gas introduced from said reaction gas introducing means collides and rectifying grooves along a flow direction of the reaction gas are provided in at least both edge portions of said wall portion. By providing the rectifying grooves, it is possible to improve the linearity of the reaction gas which decreases when the distance between the center of the ceiling plate and the substrate is less than 10 mm.

It is preferable that said rectifying grooves are provided so as to face respective holes which are arrayed in a row in the longitudinal direction of the rectifying plate facing said supply passage in a side opposite to said wall portion. By being provided in this way, it is possible to enhance the rectification property.

It is preferable that the arrayed holes are formed for each of a plurality of regions in said rectifying plate and said rectifying grooves are provided corresponding to the holes in regions located at both edges of said regions. By being provided in this way, it is possible to enhance the rectification property.

It is preferable that said rectifying grooves are provided so as to have centers of the grooves face the center of the annular sidewall portion. By being provided in this way, it is possible to enhance the rectification property.

It is preferable that a susceptor ring is provided in an outer periphery of said substrate mounting portion; and the susceptor ring consists of a first ring portion which is spaced apart in the outer periphery of the susceptor; and a second ring portion provided in an inner peripheral side of said first ring portion and placed in an opened recess. By being composed of two members in this way, it is possible to reduce the amount of heat loss.

It is preferable that said second ring portion is provided to face a spacing portion between said susceptor and said first ring portion, so as to suppress the wraparound of the reaction gas.

It is preferable that said second ring portion is provided to cover a spacing portion between said susceptor and said first ring portion, so as to further suppress the wraparound of the reaction gas.

### Effect of Invention

The epitaxial growth apparatus of the present invention can exhibit an excellent effect of improving the growth rate.

### Brief Description of Drawings

FIG. 1 is a cross-sectional view showing the whole epitaxial growth apparatus.
FIG. 2 is a partially exploded perspective view of an epitaxial growth apparatus for describing a reaction chamber.
FIG. 3 is a partial perspective view of an epitaxial growth apparatus for describing a sidewall portion.
FIG. 4 is a partial sectional view of an epitaxial growth apparatus for describing a supply passage.
FIG. 5 is a schematic diagram of an epitaxial growth apparatus for describing a supply passage.
FIG. 6 is a partial sectional view of an epitaxial growth apparatus for describing a pre-heat ring.
FIG. 7 is a partial sectional view of an epitaxial growth apparatus according to Embodiment 2..
FIG. 8 is a graph showing the results of Working Examples and Comparative Examples.

### Embodiments of Invention

### (Embodiment 1)

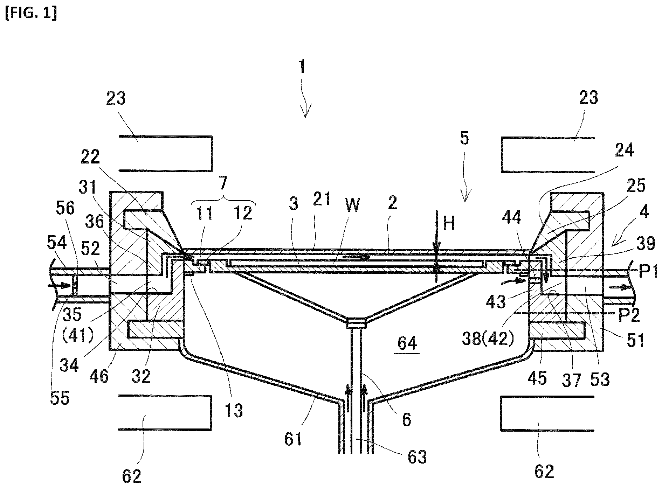

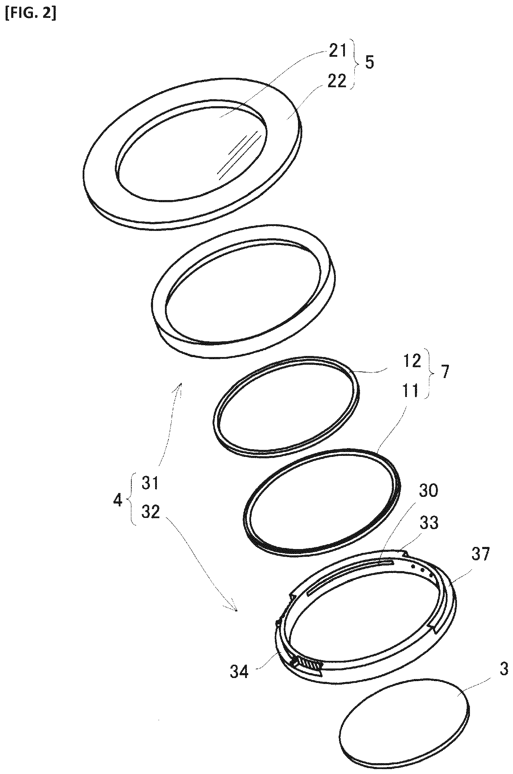

The epitaxial growth apparatus according to Embodiment 1 of the present invention will be described with reference to FIGS.1 and 2.

The epitaxial growth apparatus 1 is a film deposition apparatus for epitaxially growing a film such as silicon and the like on a substrate W.

The epitaxial growth apparatus 1 has a reaction chamber 2. The reaction chamber 2 is composed of a susceptor 3 for mounting the substrate W thereon, a sidewall portion 4 and a ceiling portion 5.

The susceptor 3 is a circular plate-like member in a top view, and is configured to be slightly larger than the substrate W. The susceptor 3 is provided with a recess 3a for a substrate for mounting a substrate W thereon. The susceptor 3 is supported by a susceptor support portion 6 having a plurality of arms. The susceptor support portion 6 moves up and down from a deposition position P1 where a film deposition is performed on a substrate W to a substrate transfer position P2 where a substrate W is loaded to and unloaded from the epitaxial growth apparatus 1 while supporting the susceptor 3. The susceptor support portion 6 is configured to rotate at the film deposition position P1 to allow the substrate W to be rotated at the film deposition position. In addition, the susceptor support portion 6 is configured so that each arm has a thickness which is thinner than the normal thickness. Thereby, the heat from a heating means 62 to be described later is prevented from being blocked by the susceptor support portion 6, it is possible to decrease the difference of the radiant heat of the susceptor 3 by the susceptor support portion 6, and it is possible to reduce the amount of heat which would otherwise escape from the susceptor 3 to the susceptor support portion 6. Therefore, it is possible to equalize the temperature distribution of the susceptor 3.

The susceptor 3 is provided with an annular susceptor ring 7 to its surroundings at the film deposition position P1. The susceptor ring 7 consists of a first ring 11 and a second ring 12 mounted on the first ring 11, though the details will be described later. The susceptor ring 7 is supported by a flange portion 13 provided on the sidewall portion 4 of the reaction chamber 2.

The ceiling portion 5 consists of a ceiling plate 21 and a support portion 22 for supporting the ceiling plate 21. The ceiling plate 21 is permeable, and is configured to allow the heat from the heating means 23 (for example, a halogen lamp) provided on the outside above the ceiling plate 21 to pass through and heat the inside of the reaction chamber 2. That is, the epitaxial growth apparatus 1 of the present embodiment is a cold-wall-type epitaxial growth apparatus. In the present embodiment, quartz is used as the ceiling plate 21.

The support portion 22 for supporting the ceiling plate is annular. A through-hole 24 of the support portion 22 has a diameter which is gradually reduced toward the substrate side. The ceiling plate is fixed to an end portion on the substrate side of the through-hole. The fixing method includes welding. In addition, seeing the support portion 22 from the back surface side (lower surface side), the inner peripheral portion projects to define a projecting portion 25. The projecting portion 25 is also formed so as to have a diameter which is gradually reduced toward the projecting direction. Thus, the support portion is composed of two slope portions.

The sidewall portion 4 consists of an annular upper sidewall portion 31 and an annular lower sidewall portion 32. The inner peripheral side of the lower sidewall portion is provided with the flange portion 13 described above. A substrate transfer port 30 is provided on the lower side of the flange portion 13.

The upper sidewall portion 31 has a slope portion on the upper surface thereof corresponding to the projecting portion 25 of the support portion 22 described above. By having this slope surface, the upper sidewall portion 31 and the support portion 22 are fitted to each other.

The upper surface of the lower sidewall portion 32 is notched in a part of the outer peripheral portion, and the region where no notch is provided is configured as a mounting surface 33 on which the upper sidewall portion is mounted. By notching the lower sidewall portion, a first recess 34 is formed in the lower sidewall portion. That is, the first recess 34 is a recess formed in a portion where the mounting surface 33 of the upper surface of the lower sidewall portion is not formed. In the upper sidewall portion 31, a first protrusion 36 is provided at a position corresponding to the first recess 34 when being mounted on the lower sidewall portion 32 so as to correspond to the shape of the first recess 34 and form a gap 35 between the first recess 34 and the first protrusion 36. In addition, the gap 35 between the first protrusion 36 and the first recess 34 functions as a reaction gas supply passage 41 (a supply passage). Details about the reaction gas supply passage 41 will be described later.

Furthermore, in the region facing the first recess 34 of the lower sidewall portion 32, the upper surface of the lower sidewall portion 32 is notched in a part of the outer periphery thereof to form a second recess 37. In the upper sidewall portion 31, a second protrusion 39 is formed at a position corresponding to the second recess 37 when being mounted on the lower sidewall portion 32 so as to correspond to the shape of the second recess 37 and form a gap 38 between the second recess 37 and the second protrusion 39. A gas discharge passage 42 is formed by the second recess 37 and the second protrusion 39 of the upper sidewall portion 31.

Thus, the reaction gas supply passage 41 and the gas discharge passage 42 are opposed to each other in the reaction chamber 2, and the reaction gas flows parallel to the horizontal direction of the substrate W in the reaction chamber 2.

In addition, a purge hole 44 through which purge gas is discharged is formed in the wall surface 43 configuring the second recess 37 of the lower sidewall portion 32. The purge hole 44 is provided below the flange portion 13. Since the purge hole 44 is provided in the wall surface 43 which configures the second recess 37, the purge hole 44 faces the gas discharge passage 42. Therefore, both of the reaction gas and the purge gas are discharged to the gas discharge passage 42.

An annular mounting table 45 is provided in the lower surface side of the sidewall portion 4, and the sidewall portion 4 is mounted on the mounting table 45.

An annular holding portion 51 is provided on the outer peripheral side of the ceiling portion 5, the sidewall portion 4 and the mounting table 45, and the annular holding portion 51 clamps and supports these ceiling portion 5, sidewall portion 4 and mounting table 45. The holding portion 51 is provided with a supply-side communication passage 52 which communicates with the reaction gas supply passage 41 and a discharge-side communication passage 53 which communicates with the gas discharge passage 42, respectively.

The supply-side communication passage 52 is provided with a reaction gas introducing portion 54. From the reaction gas introducing portion 54, a first source gas and a second source gas are introduced in the present embodiment. Note that the second source gas also functions as a carrier gas. It is also possible to use a mixture of three or more gases as a reaction gas. The reaction gas introducing portion 54 is provided with a rectifying plate 55 so as to be perpendicular to the gas flow passage. The rectifying plate 55 is provided with a plurality of holes 56 in a row along the circumferential direction. By the reaction gas passing through the holes 56, the first source gas and the second source gas are mixed as well as rectified. In addition, the discharge-side communication passage 53 is provided with a gas discharge portion 57. That is, the reaction gas supply passage is provided with the reaction gas introducing portion through the supply-side communication passage. In addition, the gas discharge passage is provided with the gas discharge portion through the discharge-side communication passage. In the gas discharge passage, the flow passage is provided so as to face the center of the reaction chamber.

In addition, an apparatus bottom portion 61 is provided in the inner peripheral side lower portion of the mounting table 45. Another heating means 62 is provided in the outside of the apparatus bottom portion 61, and it is also possible to heat the substrate from below.

In the center of the apparatus bottom portion 61, a shaft portion 63 of the susceptor support portion 6 is inserted and a purge gas introducing portion (not shown) through which a purge gas is introduced are provided. The purge gas is introduced from a purge gas introducing means which is not shown and is provided in the purge gas introducing portion into the reaction chamber lower portion 64 configured by the lower sidewall portion 32 and the mounting table 45. The purge hole 44 described above communicates with the reaction chamber lower portion 64.

A film deposition method using such an epitaxial growth apparatus of the present embodiment will be described.

The susceptor 3 is moved to the substrate transfer position P2. A substrate W is loaded from the substrate transfer port 30. The susceptor 3 is moved to the deposition position P1. A silicon substrate having a diameter of, for example, 200mm is used as the substrate W. Thereafter, while heated by the heating means 23 and 62, a purge gas (for example, hydrogen) is introduced from the purge gas introducing portion into the reaction chamber lower portion 64. In addition, reaction gases (for example, trichlorosilane as the first source gas, and hydrogen as the second source gas) are introduced from the reaction gas introducing portion 54 into the reaction chamber 2 through the reaction gas supply passage 41. The reaction gas forms a boundary layer on the substrate surface, and the reaction occurs in the boundary layer. Thereby, a silicon film is deposited on the substrate W. The reaction gas is discharged from the gas discharge passage 42 that faces the reaction chamber 2. In addition, the purge gas is discharged to the gas discharge passage 42 through the purge hole 44.

According to such an epitaxial growth apparatus of the present embodiment, the distance H between the ceiling surface in the reaction chamber side of the central portion of the ceiling plate 21 and the substrate W can be less than 10 mm due to the support portion 22 supporting the ceiling plate 21. Thereby, the epitaxial growth apparatus 1 of the present embodiment can prevent the boundary layer formed by the reaction gas flowing between the ceiling panel 21 and the susceptor 3 from spreading in the ceiling side, and as a result, the boundary layer will be narrow. Then, since the gas speed in the boundary layer increases, as a result, the gas density is improved to enhance the reaction efficiency on the substrate surface. Thereby, the growth rate can be increased in the epitaxial growth apparatus 1.

The distance H between the ceiling plate 21 and the substrate W is less than 10 mm. Preferably, the distance H between the ceiling plate 21 and the substrate W is less than 10 mm and the distance between the surface of the deposited film on the substrate and the ceiling plate 21 is set to be 1 mm or more. By adopting this range, it is possible to achieve a smooth gas stream of the reaction gas while the boundary layer is formed, which is preferable.

That is, in the reaction chamber 2 according to the present embodiment, by setting the distance between the substrate W and the ceiling plate 21 to less than ever before (conventionally, about 20 mm), the boundary layer is narrowed and the reaction efficiency on the substrate surface is enhanced. As a result, the growth rate is improved.

In the present embodiment, since the support portion 22 has a shape in which it is difficult for the stress to concentrate, it is possible in the present embodiment to set the distance H between the substrate W and the ceiling plate 21 to be short, that is, less than 10 mm. Specifically, the infrared light provided by the heating means 23 generally passes through the ceiling plate 21, but the ceiling plate 21 itself absorbs the radiation heat from the susceptor 3 or the substrate W. The absorbed heat is input from the ceiling plate 21 through the bonding portion of the support portion 22 into the support portion 22. In particular, in the present embodiment, since the distance H between the substrate W and the ceiling plate 21 is set to a predetermined short distance, the amount of absorption of the radiation heat is high and the heat which is input to the support portion 22 is greater than in the conventional technology. If the support portion 22 has a corner portion with a substantially right angle, the stress will concentrate on the corner portion and there is a possibility of cracking and the like will occur.

Therefore, the support portion 22 is tilted in order to set the ceiling plate 21 in a lower position than ever before in the present embodiment, and such a shape is employed so that the ceiling plate 21 can be supported on the substrate side without providing a corner portion where stresses tend to concentrate.

In addition, the distance H between the ceiling plate 21 and the substrate W is set to be shorter in the present embodiment in order to narrow the boundary layer as described above. As a result, the reaction gas can easily escape to the outside of the substrate W and it may be difficult to equalize the distribution of the film thickness in a substrate. Of cource, it is preferable to prevent this. Therefore, a guide portion is provided in the reaction gas supply passage 41 in the present embodiment so as to equalize the gas stream as described below.

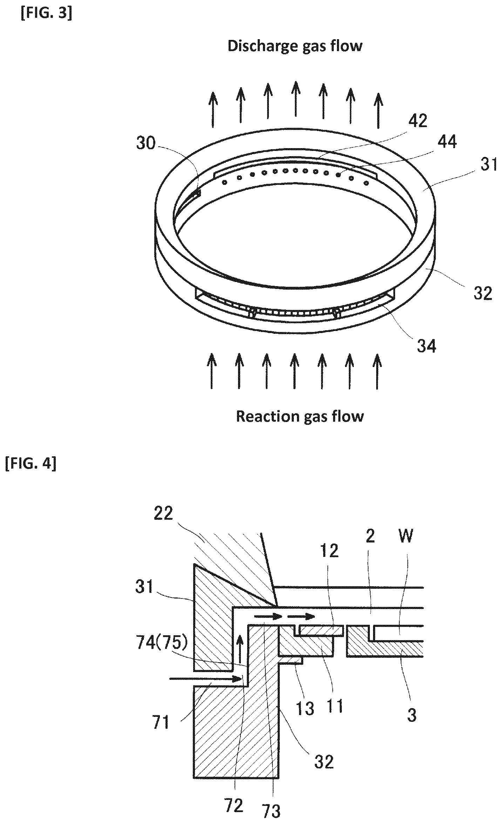

The guide portion provided in the reaction gas supply passage 41 will be described in details with reference to FIGS. 3 - 5. The reaction gas supply passage 41 formed between the first recess 34 of the lower sidewall portion 32 and the first protrusion 36 of the upper sidewall portion 31 communicates with the reaction gas introducing portion, and has a first supply passage 71 extending in a direction that matches the introducing direction of the gas from the reaction gas introducing portion. The reaction gas supply passage 41 is further provided with a second supply passage 72 which communicates with the first supply passage 71 and extends in a direction perpendicular to the introducing direction of the gas, and a third supply passage 73 which communicates with the second supply passage 72 and extends in a direction that matches the introducing direction of the gas. The third supply passage 73 is in communication with the reaction chamber 2.

The second supply passage 72 extends in the direction perpendicular to the introducing direction of the gas as described above, and thereby the gas introduced from the reaction gas introducing portion contacts with the wall surface 74 facing the reaction gas introducing portion of the second supply passage 72. Thereby, the reaction gas is diffused and the mixing characteristics of the reaction gas are increased. That is, the second supply passage 72 serves as a mixing chamber for the reaction gas. In the present embodiment, grooves 75 extending in the vertical direction are formed in the wall surface of the second supply passage 72 so that the gas will not stagnate in the second supply passage 72 in this case. The grooves 75 function as a guide portion. Due to the provision of the grooves 75, the gas diffused by contacting with the wall surface 74 of the second supply passage also easily flows into the third supply passage 73. Furthermore, by being rectified along the grooves, the linearity of the reaction gas is improved and the spreading of the reaction gas when the reaction gas flows into the reaction chamber 2 can be suppressed.

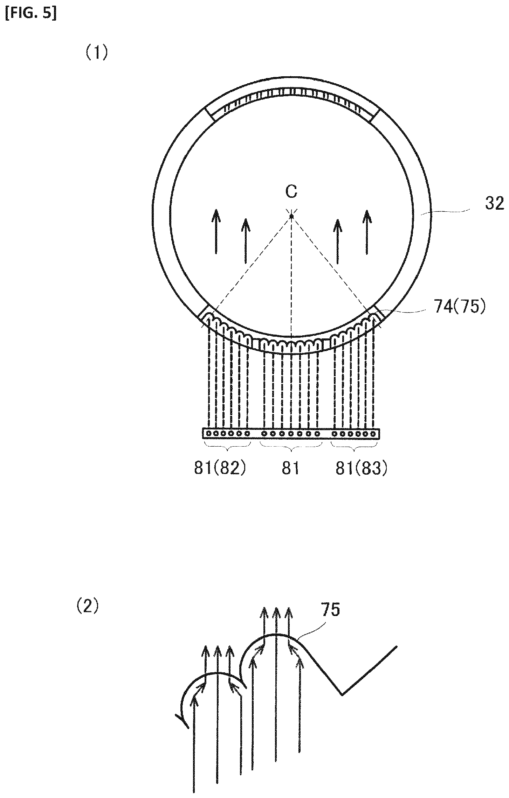

The grooves 75 will be described in details. The grooves 75 are formed as a recess having a plurality of consecutive grooves on the entire surface of the wall surface 74 of the second supply passage 74. As shown in FIG. 5 (2), the recessed grooves 75 are curved in the width direction of the grooves. In the present embodiment, the grooves 75 are arcuate in a top view. Since the grooves 75 are curved in the width direction, the reaction gas is difficult to be diffused (easily concentrated), when the reaction gas contacts the wall surface 74, that is, the bottom of the grooves 75, and even when the reaction gas flows into the reaction chamber, the reaction gas is less likely to be spread to the outside of the substrate. Note that when the depth of the grooves 75 is too deep, it is possible to suppress the diffusion, but it is difficult to mix the first source gas and the second source gas in the reaction gas. Thus, in the present embodiment, the depth of the grooves 75 is 3 mm.

In addition, each of the grooves 75 is provided toward the center C in the plane direction of the lower sidewall portion 32. That is, the grooves 75 are provided along the circumferential direction of the lower sidewall portion 32. By providing the grooves 75 in this way, the rectifying property increases so that the reaction gas guided by each of the grooves 75 is directed to the center side, and the reaction gas is prevented from being dispersed in the reaction chamber.

Furthermore, each of the grooves 75 is provided in such a position that the center of each of the grooves in the width direction and the center of the holes 56 of the rectifying plate 55 provided on the reaction gas introducing portion are substantially matched (corresponding). That is, in the present embodiment, the number of the grooves 75 in the wall surface 74 and the number of the holes 56 are equal. Thereby, since the reaction gas rectified by the rectifying plate 55 flows into each of the grooves 75 directly, the rectifying property is further enhanced and the linearity of the reaction gas is improved.

Note that the grooves 75 are provided on the entire surface of the wall surface 74 of the second supply passage 72 in the present embodiment. However, the grooves 75 have only to be provided at least in edge portions among the wall surfaces 74 of the second supply passage 72. Although holes of the rectifying plate are provided by being divided into a plurality of regions, the edge portions refer to portions corresponding to extreme regions of the regions. For example, in the case shown in FIG. 5, the rectifying plate is divided into three regions 81, and the grooves 75 have only to be provided corresponding to the holes in the extreme regions 82 and 83 of the regions. Since the reaction gas easily escapes to the outside of the substrate as described above, it is preferable that the grooves 75 are provided in order to enhance the linearity of the reaction gas at the edge portions of the reaction gas supply passage in particular. Then, it is possible to obtain such an effect simply by forming the grooves 75 which functions as a guide portion in this case as a recess. For example, it is not preferable to provide a rectifying member in the second supply passage separately, because problems of the reaction gas mixing property, production cost and the like will occur. So it is preferable to form the grooves 75 as a recess as described in the present embodiment. Then, since a desired effect can be achieved by rectifying the reaction gas with the grooves 75, it is not necessary to perform a separate control for the reaction gas introducing portion.

Furthermore, in the present embodiment, the distance between the ceiling plate 21 and the substrate W is deceased in order to narrow the boundary layer as described above. Thus, the wraparound of the reaction gas to the lower portion of the reaction chamber occurs easily and it is difficult to equalize the temperature distribution of the substrate. As a result, the decrease in the film thickness distribution and the film quality (such as the distribution of the resistivity, the occurrence of the crystal defects, etc.) when a thick film is formed has also been considered. In the present embodiment, the susceptor ring 7 is composed of two members in order to further prevent the decrease in the film thickness distribution and the film quality. This point will be described.

The susceptor ring 7 is intended to function as a preheat ring. A first ring 11 configuring the susceptor ring 7 is spaced apart with respect to the outer periphery of the susceptor, and a step portion 91 having a low upper surface is formed on the inner peripheral side of the first ring. A second ring 12 is mounted on the step portion 91. The second ring 12 faces the spacing portion 92 formed between the first ring 11 and the susceptor 3, that is, the second ring 12 is provided so as to protrude toward the spacing portion 92. The second ring 12 is provided so that the upper surface thereof may have the same height as the upper surface of the susceptor 3. Thus, by the upper surface of the second ring 12 provided to have the same height as the upper surface of the susceptor 3, the reaction gas which is maintained in a state to be mixed and rectified by the reaction gas supply passage 41 and the like can be smoothly supplied to the substrate W so as not to reduce the speed as much as possible. Note that the upper surface of the susceptor 3 here refers to an upper surface of a region where no recess 3a (refer to FIG. 1) for a substrate of the susceptor 3 is formed. The second ring 12 of the present embodiment employs silicon carbide as a material in view of the thermal conductivity.

Then, the susceptor ring 7 can be configured more accurately by configuring the second ring 12 and the first ring 11 as separate members in this manner. That is, it is possible to bring the distance between the susceptor ring 7 and the susceptor 3 close to a lower limit, and thereby the wraparound of the reaction gas to the back surface side of the substrate W, that is, to the reaction chamber lower portion 64 can be reduced and the temperature distribution of the substrate can be equalized. Thus, in the present embodiment, the distribution of the film thickness and the distribution of the film quality of the formed film are equalized.

In addition, the heat transfer between the first ring 11 and the second ring 12 can be suppressed by making the first ring 11 and the second ring 12 as two members more than in the case of making the first ring 11 and the second ring 12 as one member.

Furthermore, leakage of the reaction gas downward from between the susceptor ring 7 and the susceptor 3 during the film deposition can be reduced and the flow of the reaction gas is hardly disturbed by the second ring 12 configured to face the spacing portion 92 in this manner. In addition, since the downward leakage of the reaction gas can be reduced, it is possible to reduce the amount of particles.

In this case, the second ring 12 is formed to be thinner than the first ring 11. Thereby, it is possible to suppress the radiation heat loss from the susceptor 3. Furthermore, since the second ring 12 is thin, it is possible to reduce the amount of heat required for maintaining (preheating) the second ring 12 in a predetermined high temperature. In addition to the present embodiment, when the first ring 11 is made of a material having a low thermal conductivity, the first ring 11 functions as a heat insulating material, and it is possible to further enhance the above effect.

Note that the second ring 12 is configured so as to face the spacing portion 92 in the present embodiment, but it is not limited thereto. At least if the second ring 12 is configured to be mounted on the step portion 91 of the first ring 11, it is possible to configure the susceptor ring 7 accurately. So the distance between the susceptor ring 7 and the susceptor 3 can be brought close to a lower limit. Thereby, the wraparound of the reaction gas to the back surface side of the substrate W can be reduced and the temperature distribution of the substrate can be equalized.

In addition, since the distance between the ceiling plate 21 and the substrate W is decreased in order to narrow the boundary layer in the present embodiment, the ceiling surface of the ceiling plate 21 is also likely to be coated with the reaction gas. If the ceiling surface is coated, the ceiling surface is fogged and the film deposition may not be performed sufficiently, by the cold-wall-type epitaxial apparatus, to be heated from the heating means 23 through the ceiling plate 21. In contrast, in the present embodiment, by providing the grooves 75 on the wall surface of the reaction gas supply passage 41 and configuring the susceptor ring 7 with two members as described above, the reaction gas is hardly retained in the reaction chamber, and as a result, the adhesion of the coating material can be suppressed. Thereby, it is possible to perform sufficient and multiple film deposition steps in succession.

### (Embodiment 2)

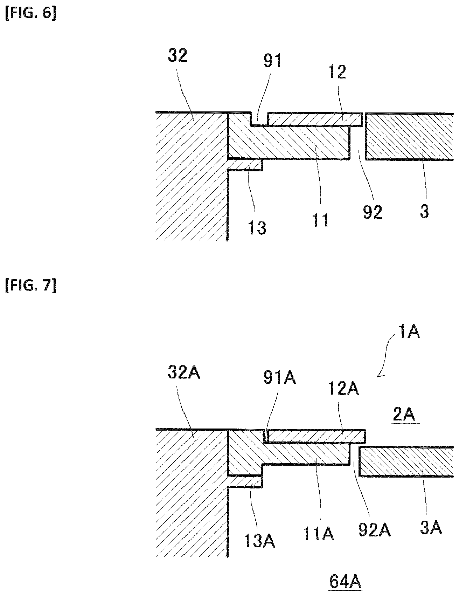

Another embodiment of the present invention will be described with reference to FIG. 7.

In the epitaxial growth apparatus 1A according to the present embodiment, the second ring 12A is provided so as to cover the spacing portion 92A, which is different from Embodiment 1. In the present embodiment, the first ring 11A is also mounted on the flange portion 13A of the sidewall portion 32A. The second ring 12A is mounted on the step portion 91A of the first ring 11A and the inner peripheral side thereof faces the outer periphery of the susceptor 3A.

In the present embodiment, since the second ring 12A is provided so as to cover the spacing portion 92A, it is possible to further prevent the reaction gas flowing into the reaction chamber 2A from entering into the reaction chamber lower portion 64A. In order to prevent the second ring 12A from blocking the heating of the susceptor 3A from a heating means not shown in FIG. 7, the amount of the overlap between the second ring 12A and the susceptor 3A is preferably small.

The thickness of the second ring 12A in such present embodiment is about 0.8 mm. By using such a thickness, heat loss by radiation from the susceptor 3A to the second ring 12A can be suppressed as much as possible.

### (WORKING EXAMPLES)

Hereinafter, the details of the invention will be described by way of working examples.

### Working Example 1

By the epitaxial growth apparatus 1A (the distance H between the substrate surface and the ceiling plate 21 is 9.27 mm), an epitaxial growth is performed on the basis of the following growth conditions.
First source gas (trichlorosilane) flow rate 8.5 SLM
Second source gas (hydrogen) flow rate 80.0 SLM
Purge gas (hydrogen) flow rate 15.0 SLM
Growth time 600.0 seconds
Growth temperature 1100.0 °C
Rotation speed 20.0 RPM

### Working Example 2

An epitaxial growth is performed in the same conditions as in Working Example 1 except for changing the first source gas flow rate to 13.5 SLM.

### Working Example 3

An epitaxial growth is performed in the same conditions as in Working Example 1 except for changing the first source gas flow rate to 17.0 SLM.

### (COMPARATIVE EXAMPLE 1)

An epitaxial growth is performed by a conventional epitaxial growth apparatus (the distance H between the substrate surface and the ceiling plate 21 is 20 mm, no grooves 75 are provided, and the susceptor ring consists of one member) on the basis of the same growth conditions as in Working Example 1 except for the second source gas flow rate of 34.0 SLM and the rotation speed of 35.0 RPM.

### (COMPARATIVE EXAMPLE 2)

An epitaxial growth is performed by a conventional epitaxial growth apparatus (the distance H between the substrate surface and the ceiling plate 21 is 20 mm, no grooves 75 are provided, and the susceptor ring consists of one member) on the basis of the same growth conditions as in Working Example 2 except for the second source gas flow rate of 34.0 SLM and the rotation speed of 35.0 RPM.

### (COMPARATIVE EXAMPLE 3)

An epitaxial growth is performed by a conventional epitaxial growth apparatus (the distance H between the substrate surface and the ceiling plate 21 is 20 mm, no grooves 75 are provided, and the susceptor ring consists of one member) on the basis of the same growth conditions as in Working Example 3 except for the second source gas flow rate of 34.0 SLM and the rotation speed of 35.0 RPM.

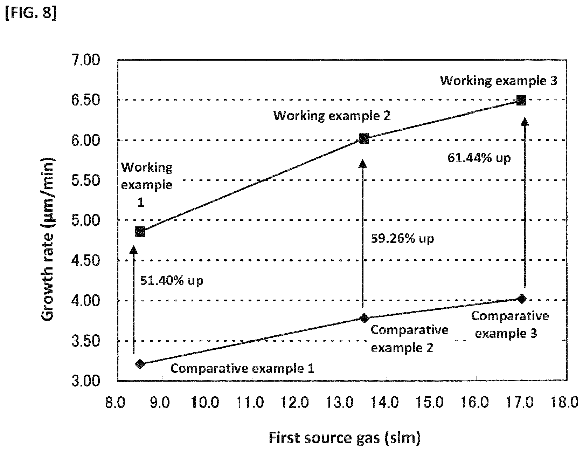

The growth rate of the film according to each of Working Examples and Comparative Examples was detected. The relation between the detected growth rate and the first source gas is shown in FIG. 8.

As shown in FIG. 8, according to the epitaxial growth apparatus 1A, the growth rate was improved by more than 50 %. The more the first source gas amount was, the more the growth rate was improved. Therefore, the growth rate was improved by using the epitaxial growth apparatus of the present embodiment.

### Reference Signs List

- 1: Epitaxial growth apparatus
- 2: Reaction chamber
- 3: Susceptor
- 4: Sidewall portion
- 5: Ceiling portion
- 6: Susceptor support portion
- 7: Susceptor ring
- 11: First ring
- 12: Second ring
- 13: Flange portion
- 21: Ceiling plate
- 22: Support portion
- 23: Heating means
- 24: Through-hole
- 25: Projecting portion
- 30: Substrate unloading port
- 31: Upper sidewall portion
- 32: Lower sidewall portion
- 33: Mounting surface
- 34: First recess
- 35: Gap
- 36: First protrusion
- 37: Second recess
- 38: Gap
- 39: Second protrusion
- 41: Reaction gas supply passage
- 42: Gas discharge passage
- 43: Wall surface
- 44: Purge hole
- 45: Mounting table
- 51: Holding portion
- 52: Supply-side communication passage
- 53: Discharge-side communication passage
- 54: Reaction gas introducing portion
- 55: Rectifying plate
- 56: Hole
- 57: Gas discharge portion
- 61: Apparatus bottom portion
- 62: Heating means
- 63: Shaft
- 64: Reaction chamber lower portion
- 71: First supply passage
- 72: Second supply passage
- 73: Third supply passage
- 74: Wall surface
- 75: Groove
- 81, 82, 83: Region
- 91: Step portion
- 92: Spacing portion
- W: Substrate

## Claims

1. An epitaxial growth apparatus, comprising:
a reaction chamber (2) defined by a substrate mounting portion (3) on which a substrate (W) is mounted, a ceiling plate (21) with optical transparency and a sidewall portion (4);
a heating means (23) which is mounted outside said reaction chamber and heats the substrate mounted in said reaction chamber through said ceiling plate; and
a reaction gas introducing means which introduces a reaction gas parallel to a horizontal direction of the substrate into said reaction chamber, **characterized in that**:
a distance (H) between a center of said ceiling plate and the substrate mounted on said substrate mounting portion is configured to be less than 10 mm; and
a susceptor ring (7) is provided in an outer periphery of said substrate mounting portion; and
the susceptor ring consists of: a first ring portion (11) provided to be spaced apart with respect to an outer periphery of the substrate mounting portion; and a second ring portion (12) provided in an inner peripheral side of said first ring portion and placed in an opened recess.

2. The epitaxial growth apparatus of claim 1, **characterized in that**
said ceiling plate is fixed to an annular support portion (22) in which through-holes are formed in a top view; and
the through-holes in said support portion have diameters gradually reduced toward said substrate side and said ceiling plate is fixed to an edge portion on the substrate side.

3. The epitaxial growth apparatus of claim 1 or 2, **characterized in that**
a supply passage (41) which supplies a reaction gas into said reaction chamber is formed in said sidewall portion; and
said supply passage has a wall portion where the reaction gas introduced from said reaction gas introducing means collides and rectifying grooves (75) along a flowing direction of the reaction gas are provided in at least both edge portions of said wall portion.

4. The epitaxial growth apparatus of claim 3, **characterized in that**
said rectifying grooves are provided so as to face respective holes which are arrayed in a row in the longitudinal direction of the rectifying plate (55) facing said supply passage in a side opposite to said wall portion.

5. The epitaxial growth apparatus of claim 3, **characterized in that**
holes which are arrayed are formed for each of a plurality of regions in said rectifying plate and said rectifying grooves are provided corresponding to the holes in regions located at both edges of said regions.

6. The epitaxial growth apparatus of any of claims 3 - 5, **characterized in that**
said rectifying grooves are provided so as to have centers of the grooves face the center of the annular sidewall portion.

7. The epitaxial growth apparatus of claim 1, **characterized in that**
said second ring portion is provided to face a spacing portion between said substrate mounting portion and said first ring portion.

8. The epitaxial growth apparatus of claim 7, **characterized in that**
said second ring portion is provided to cover a spacing portion between said substrate mounting portion and said first ring portion.

## Patentansprüche

1. Epitaxial-Wachstumsvorrichtung, umfassend:
eine Reaktionskammer (2), die durch einen Substratmontierteil (3), auf dem ein Substrat (W) montiert ist, eine Deckplatte (21) mit optischer Transparenz und ein Seitenwandteil (4) definiert ist;
ein Heizmittel (23), das außerhalb der Reaktionskammer befestigt ist und das Substrat, das in der Reaktionskammer montiert ist, durch die Deckplatte erwärmt; und
ein reaktionsgaseinleitendes Mittel, das ein Reaktionsgas parallel zu einer horizontalen Richtung des Substrats in die Reaktionskammer einleitet,
**dadurch gekennzeichnet, dass**:
ein Abstand (H) zwischen einer Mitte der Deckplatte und dem Substrat, das auf dem Substratmontierteil montiert ist, dafür ausgelegt ist, kleiner als 10 mm zu sein; und
einen Suszeptorring (7), der in einer äußeren Peripherie des Substratmontierteils vorgesehen ist; und
wobei der Suszeptorring besteht aus: einem ersten Ringteil (11), der für die Anordnung mit Abstand von einer äußeren Peripherie des Substratmontierteils vorgesehen ist; und einen zweiten Ringteil (12), der in einer inneren Peripherieseite des ersten Ringteils vorgesehen und in einer geöffneten Vertiefung platziert ist.

2. Epitaxial-Wachstums-Vorrichtung nach Anspruch 1, **dadurch gekennzeichnet, dass**
die Deckplatte an einem ringförmigen Stützteil (22) befestigt ist, in dem Durchgangslöcher in einer Draufsicht gebildet sind; und
die Durchgangslöcher im Stützteil Durchmesser haben, die allmählich zur Substratseite hin reduziert werden,
und die Deckplatte an einem Kantenteil auf der Substratseite befestigt ist.

3. Epitaxial-Wachstumsvorrichtung nach Anspruch 1 oder 2, **dadurch gekennzeichnet, dass**
ein Zufuhrdurchgang (41), der ein Reaktionsgas der Reaktionskammer zuführt, im Seitenwandteil gebildet ist; und
der Zufuhrdurchgang einen Wandteil hat, wo das Reaktionsgas, das vom Reaktionsgaseinleitungsmittel eingeleitet wird, kollidiert, und bereinigende Nuten (75) entlang einer Strömungsrichtung des Reaktionsgases sind in den mindestens beiden Kantenteilen des Wandteils vorgesehen.

4. Epitaxial-Wachstumsvorrichtung nach Anspruch 3, **dadurch gekennzeichnet, dass**
die bereinigenden Nuten vorgesehen sind, um so den jeweiligen Löchern gegenüberzuliegen, die in einer Reihe in Längsrichtung der bereinigenden Platte (55) aufgereiht sind, welche dem Zufuhrdurchgang in einer Seite gegenüber dem Wandteil zugewandt ist.

5. Epitaxial-Wachstumsvorrichtung nach Anspruch 3, **dadurch gekennzeichnet, dass**
Löcher, die in einer Reihe angeordnet sind, für jeden einer Vielzahl von Bereichen in der bereinigenden Platte gebildet sind, und die bereinigenden Nuten sind dafür vorgesehen, den Löchern in Bereichen zu entsprechen, die sich an beiden Kanten der Bereiche befinden.

6. The epitaxial growth apparatus of any of claims 3 - 5, **characterized in that**
die bereinigenden Nuten so vorgesehen sind, dass sie Nutenmitten haben, die der Mitte des ringförmigen Seitenwandteils gegenüberliegen.

7. Epitaxial-Wachstumsvorrichtung nach Anspruch 1, **dadurch gekennzeichnet, dass**
der zweite Ringteil so vorgesehen ist, dass er einem Abstandsteil zwischen dem Substratmontierteil und dem ersten Ringteil gegenüberliegt.

8. Epitaxial-Wachstumsvorrichtung nach Anspruch 7, **dadurch gekennzeichnet, dass**
der zweite Ringteil dafür vorgesehen ist, einen Abstandsteil zwischen dem Substratmontierteil und dem ersten Ringteil zu bedecken.

## Revendications

1. Appareil à croissance épitaxiale, comprenant :
une chambre de réaction (2) définie par une partie de montage de substrat (3) sur laquelle est monté un substrat (W), une plaque de plafond (21) avec une transparence optique et une partie de paroi latérale (4) ;
un moyen de chauffage (23) monté à l'extérieur de ladite chambre de réaction et chauffant le substrat monté dans ladite chambre de réaction à travers ladite plaque de plafond ; et
un moyen d'introduction de gaz de réaction, introduisant un gaz de réaction parallèlement à une direction horizontale du substrat dans ladite chambre de réaction, **caractérisé en ce que** :
une distance (H) entre un centre de ladite plaque de plafond et le substrat monté sur ladite partie de montage de substrat est configurée de manière à être inférieure à 10 mm ; et
un anneau de suscepteur (7) est prévu dans une périphérie extérieure de ladite partie de montage de substrat ; et
l'anneau de suscepteur est constitué de : une première partie d'anneau (11) conçue de manière à être espacée par rapport à une périphérie extérieure de la partie de montage de substrat ; et une deuxième partie d'anneau (12) disposée dans un côté périphérique intérieur de ladite première partie d'anneau et placée dans une cavité ouverte.

2. Appareil à croissance épitaxiale selon la revendication 1, **caractérisé en ce que**
ladite plaque de plafond est fixée à une partie de support annulaire (22) dans laquelle des trous de passage sont formés dans une vue d'au-dessus ; et
les trous de passage dans ladite partie de support présentent des diamètres progressivement réduits vers ledit côté substrat et ladite plaque de plafond est fixée à une partie de bord sur le côté substrat.

3. Appareil à croissance épitaxiale selon la revendication 1 ou 2, **caractérisé en ce que**
un passage d'alimentation (41) alimentant un gaz de réaction vers ladite chambre de réaction est formé dans ladite partie de paroi latérale ; et
ledit passage d'alimentation comporte une partie de paroi à laquelle se heurte le gaz de réaction introduit depuis ledit moyen d'introduction de gaz de réaction et des rainures de rectification (75) le long d'une direction d'écoulement du gaz de réaction sont prévues au moins dans les deux parties de bord de ladite partie de paroi.

4. Appareil à croissance épitaxiale selon la revendication 3, **caractérisé en ce que**
lesdites rainures de rectification sont disposées de manière à être tournées vers des trous respectifs agencés en réseau dans une rangée dans la direction longitudinale de la plaque de rectification (55) tournée vers ledit passage d'alimentation dans un côté opposé à ladite partie de paroi.

5. Appareil à croissance épitaxiale selon la revendication 3, **caractérisé en ce que**
des trous agencés en réseau sont formés pour chacune parmi une pluralité de régions dans ladite plaque de rectification et lesdites rainures de rectification sont disposées de manière à correspondre aux trous dans des régions situées au niveau des deux bords desdites régions.

6. Appareil à croissance épitaxiale selon l'une quelconque des revendications 3 à 5, **caractérisé en ce que**
lesdites rainures de rectification sont conçues de manière à ce que des centres des rainures soient tournés vers le centre de la partie de paroi latérale annulaire.

7. Appareil à croissance épitaxiale selon la revendication 1, **caractérisé en ce que**
ladite deuxième partie d'anneau est conçue de manière à être tournée vers une partie d'espacement entre ladite partie de montage de substrat et ladite première partie d'anneau.

8. Appareil à croissance épitaxiale selon la revendication 7, **caractérisé en ce que**
ladite deuxième partie d'anneau est conçue de manière à recouvrir une partie d'espacement entre ladite partie de montage de substrat et ladite première partie d'anneau.
